# EUROPEAN PATENT APPLICATION

(11) **EP 4 723 840 A1**
(43) Date of publication of application: **08.04.2026**
(21) Application number: 25199977.7
(22) Date of filing: 03.09.2025
(51) Int. Cl.: H10F 39/00, G03B 17/55

(54) **SENSOR APPARATUS**

(30) Priority: 01.10.2024 JP 2024172010
(71) Applicant: Canon Kabushiki Kaisha, Tokyo, 146-8501 (JP)
(72) Inventor: HIRANO, Yusuke, Tokyo, 146-8501 (JP)
(74) Representative: Canon Europe Limited

(57) **Abstract**

A sensor apparatus (1) includes a housing (4), a sensor component (9), a sensor substrate (10) carrying the sensor component, a cured paste (13) located on a surface of the sensor substrate that is adjacent to the housing, and a sheet member (7) located between the cured paste and the housing. The sensor substrate, the cured paste, the sheet member, and the housing are arranged in that order, and each of the sensor substrate, the cured paste, the sheet member, and the housing is in contact with an adjoining one of the sensor substrate, the cured paste, the sheet member, and the housing to transfer heat from the sensor substrate to the housing through the cured paste and the sheet member.

## Description

### TECHNICAL FIELD

The present disclosure relates to a sensor apparatus including a thermally conductive cured paste.

### BACKGROUND

An imaging apparatus includes an imaging element, which is a sensor configured to receive light from an object, and an imaging element substrate carrying the imaging element. The imaging element consumes a large amount of power and thus generates heat, which can cause problems, such as degradation in image quality and a shortened service life.

To efficiently dissipate heat from the imaging element, a heat dissipating structure based on heat conduction is often used. The heat dissipating structure includes a thermally conductive member placed between the imaging element substrate and a housing. The imaging element is adjusted in units of µm to a focus position of an optical system including lenses and is then secured. A mechanical stress on the imaging element substrate causes a change in the focus position. For an imaging apparatus in which a distance is measured based on the principle of triangulation, the distance is calculated from the focus position. A change in the focus position affects distance measurement. For this reason, a film-shaped thermally conductive member such as a graphite sheet, which is highly flexible, is used because such a member has little impact on the imaging element secured. The film-shaped thermally conductive member, which is thin and highly flexible, joining the imaging element substrate and the housing can reduce a mechanical stress induced by thermal expansion or thermal contraction. For example, Japanese Patent Laid-Open No. 2023-157249 discloses such an imaging apparatus.

However, if the film-shaped thermally conductive member used is a graphite sheet having a very high thermal conductivity, such a thin member can provide insufficient heat conduction, causing poor heat dissipation. The film-shaped thermally conductive member has further problems. For example, the film-shaped thermally conductive member can apply a mechanical stress to the imaging element substrate when stuck on the substrate. The film-shaped thermally conductive member can be attached only to a flat surface. The film-shaped thermally conductive member fails to uniformly transfer heat from the substrate because heat transfers in a longitudinal direction of the member. A thermally conductive curable paste is used as a material that solves the above problems. When the thermally conductive curable paste is placed between the imaging element substrate and the housing, the thermally conductive curable paste can reduce a mechanical stress during placement because the paste remains uncured during placement. After placement, the paste cures and thus directly joins two components. If the two components joined are arranged at a short distance from each other, this arrangement is effective in heat transfer. After the thermally conductive curable paste cures, however, heat-induced expansion or contraction of the cured paste applies a mechanical stress to the imaging element substrate, causing a shift in the position of the sensor, which is sensitive to position accuracy.

### SUMMARY

The present disclosure is directed to a sensor apparatus that includes a housing, a sensor, an imaging element substrate, and a thermally conductive cured paste joining the housing and the imaging element substrate such that an efficient heat dissipating structure is maintained and in which the impact of thermal expansion or contraction of the thermally conductive cured paste on the sensor is reduced to improve measurement accuracy.

The present disclosure in its first aspect provides a sensor apparatus as specified in claim 1. Optional features are specified in claims 2 to 7, 10, 12 and 13.

The present disclosure in its second aspect provides a sensor apparatus as specified in claim 8. Optional features are specified in claims 9, 10, 12 and 13.

The present disclosure in its third aspect provides a sensor apparatus as specified in claim 11. Optional features are specified in claims 12 and 13.

Features of the present disclosure will become apparent from the following description of embodiments with reference to the attached drawings. The following description of embodiments is described by way of example.

### BRIEF DESCRIPTION OF THE DRAWINGS

Figs. 1A to 1D are diagrams each illustrating an imaging apparatus according to a first embodiment of the present disclosure mounted on a vehicle.
Fig. 2 is a block diagram illustrating an example configuration of the imaging apparatus according to the first embodiment of the present disclosure.
Figs. 3A and 3B are a perspective view and an exploded perspective view, respectively, of the imaging apparatus according to the first embodiment.
Fig. 4 is a sectional view of the imaging apparatus according to the first embodiment.
Figs. 5A and 5B are diagrams illustrating a portion including a thermally conductive member of the imaging apparatus according to the first embodiment.
Figs. 6A and 6B are conceptual diagrams illustrating the principle of distance measurement in the first embodiment.
Figs. 7A to 7F are diagrams illustrating a portion including a thermally conductive member of an imaging apparatus according to a second embodiment.
Figs. 8A and 8B are diagrams illustrating a portion including a thermally conductive member of an imaging apparatus according to a modification of the second embodiment.
Figs. 9A to 9C are diagrams illustrating various cuts in a sheet member included in the imaging apparatus according to the modification of the second embodiment.
Figs. 10A and 10B are diagrams illustrating a portion including a thermally conductive member of an imaging apparatus according to a third embodiment.
Figs. 11A and 11B are diagrams illustrating a portion including a thermally conductive member of an imaging apparatus according to a first modification of the third embodiment.
Figs. 12A and 12B are diagrams illustrating a portion including a thermally conductive member of an imaging apparatus according to a second modification of the third embodiment.
Fig. 13 is a sectional view illustrating a sensor apparatus according to a third modification of the third embodiment.

### DESCRIPTION OF THE EMBODIMENTS

### First Embodiment

A first embodiment of the present disclosure will be described below. The figures used in the following description are simplified and schematic. In the figures, for example, the dimensional ratio does not necessarily match the actual one.

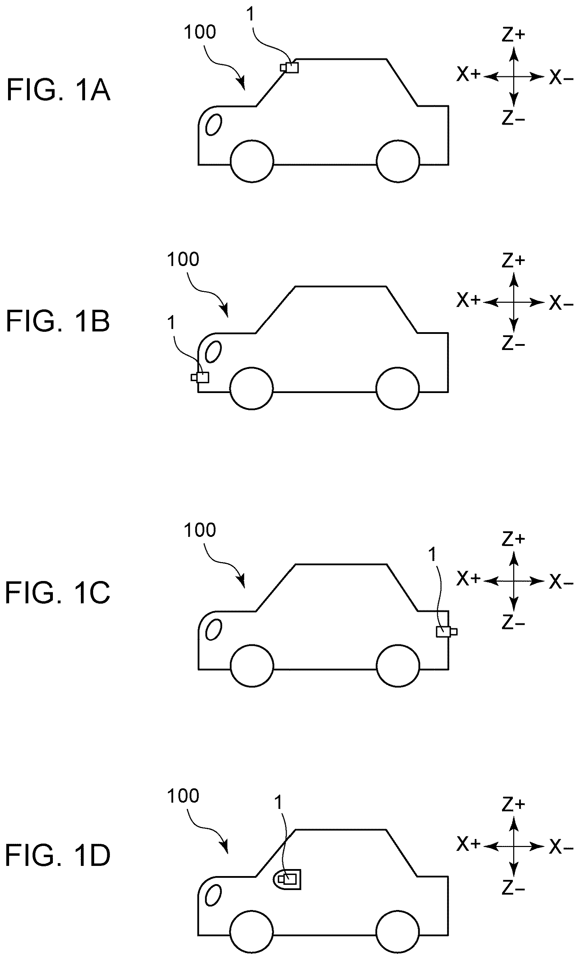

An imaging apparatus 1 according to the first embodiment of the present disclosure can be mounted on a vehicle 100, which is a moving object. Fig. 1A is a diagram illustrating the position of the imaging apparatus 1 mounted on the vehicle 100. The imaging apparatus 1 mounted on the vehicle 100 is a vehicle-mounted camera. The imaging apparatus 1 monitors areas in front of and to the sides of the vehicle 100 while the vehicle 100 is traveling, and can be disposed close to an upper portion of a windshield or an upper portion of an A-pillar in the interior of the vehicle 100. Fig. 1B illustrates the imaging apparatus 1 disposed close to a grille, a bumper, or a headlight at the front of the vehicle to monitor areas in front of and to the sides of the vehicle 100 while the vehicle 100 is traveling. Fig. 1C illustrates the imaging apparatus 1 disposed on the rear of the vehicle 100 to monitor areas behind and to the sides of the vehicle 100. Fig. 1D illustrates the imaging apparatus 1 disposed on a side mirror of the vehicle 100 to monitor areas in front of, behind, and to the left of the vehicle 100. Examples of the vehicle-mounted camera are not limited to those described above and include imaging apparatuses installed at various positions where images of areas in front of, behind, and to the sides of a vehicle can be captured. Imaging Apparatus in Vehicle and Vehicle Control Function

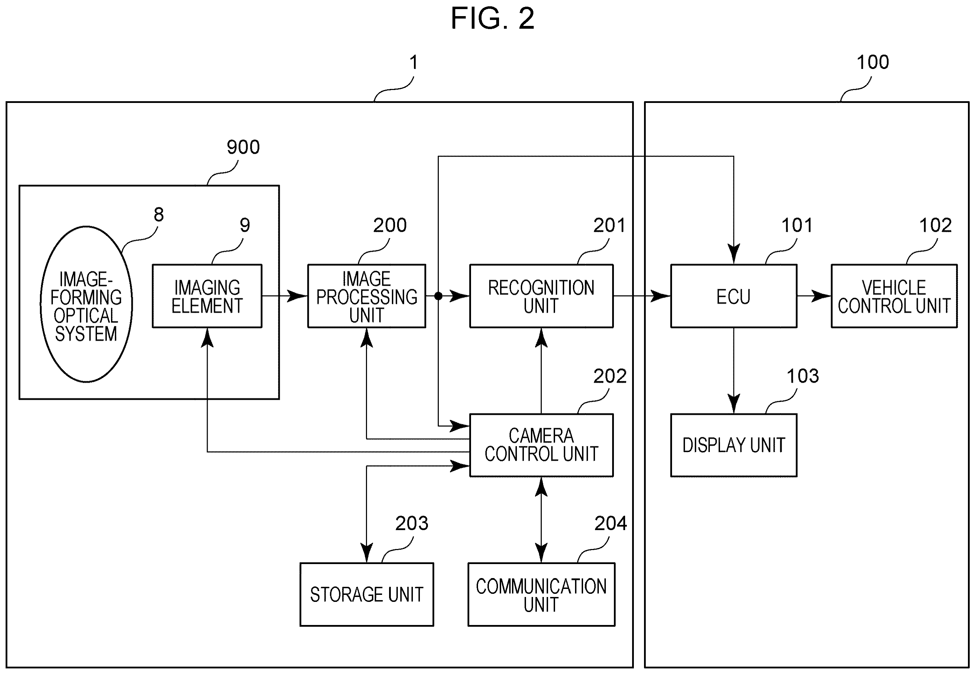

The imaging apparatus 1 according to the first embodiment and the vehicle 100 will now be described. Fig. 2 is a diagram illustrating functional blocks of the imaging apparatus 1 according to the present embodiment and those of the vehicle 100. A subset of the functional blocks illustrated in Fig. 2 is implemented by causing a computer (not illustrated) included in each of the imaging apparatus 1 and the vehicle 100 to execute a computer program stored in a memory as a storage medium (not illustrated).

A subset or all of the functional blocks may be implemented by hardware. Examples of hardware include a dedicated circuit (application specific integrated circuit or ASIC) and processors such as a reconfigurable processor and a digital signal processor (DSP). The functional blocks illustrated in Fig. 2 do not necessarily need to be contained in the same housing. The functional blocks may serve as separate devices connected to each other via signal paths.

The imaging apparatus 1 includes an imaging element 9 (sensor component), an image-forming optical system 8, an image processing unit 200, a recognition unit 201, a camera control unit 202, a storage unit 203, and a communication unit 204. The imaging element 9 (sensor component) is a semiconductor image sensor, such as a complementary metal oxide semiconductor (CMOS) sensor.

The imaging apparatus 1 according to the present embodiment is mounted on the vehicle 100. The image-forming optical system 8 and the imaging element 9 constitute a camera unit 900. For example, the camera unit 900 is configured to capture an image of at least one of an area in front of the vehicle 100, an area behind the vehicle 100, and an area to a side of the vehicle 100. Multiple camera units 900 may be mounted on the vehicle 100.

The image processing unit 200 performs image processing, such as black level correction, gamma correction, noise reduction, digital gain adjustment, demosaicing, and data compression, on an image signal acquired by the imaging element 9 to generate a final image signal.

The image processing unit 200 outputs the image signal to the recognition unit 201, the camera control unit 202, and an electric control unit (ECU) 101 of the vehicle 100.

The recognition unit 201 performs image recognition based on the image signal to identify an object, such as a human or a vehicle, around the vehicle 100. Such a recognition process uses deep learning. For example, You Only Look Once (YOLO), which enables easy training and fast detection, can be used as a deep learning model. Examples of deep learning models include Single Shot MultiBox Detector (SSD), Faster Region-based Convolutional Neural Network (R-CNN), Fast R-CNN, and R-CNN.

In the present embodiment, the recognition unit 201 calculates a distance to the identified object. Example methods of calculating a distance include a method of estimating a distance using deep learning. For example, information on a blur of an image of a detected object is analyzed using deep learning, thereby calculating a distance value. Other example methods of calculating a distance include a method of calculating a distance using the principle of triangulation. The recognition process including such distance estimation is performed on an image inputted from the image processing unit 200. The result of recognition is outputted to the subsequent ECU 101.

In the present embodiment, the imaging apparatus 1 mounted on the vehicle will be described as an example. The imaging apparatus 1 may be mounted on any movable object such as an aircraft, a train, a ship, a drone, an automated guided vehicle (AGV), or a robot.

The camera control unit 202 includes a central processing unit (CPU), serving as a computer, and a memory storing a computer program. The CPU executes the computer program stored in the memory, thereby controlling the units of the imaging apparatus 1.

The camera control unit 202 serves as a controller. For example, the camera control unit 202 controls the length of exposure time for each frame of the imaging element 9 and the timing of a control signal.

The storage unit 203 includes a recording medium, such as a memory card or a hard disk, into and from which image signals can be stored and read. The communication unit 204 includes wireless and wired interfaces and is configured to output a generated image signal to the outside of the imaging apparatus 1 and receive various signals from the outside.

The ECU 101 includes a CPU, serving as a computer, and a memory storing a computer program. The CPU executes the computer program stored in the memory, thereby controlling the units of the vehicle 100.

The ECU 101 supplies its output to a vehicle control unit 102 and a display unit 103. The vehicle control unit 102 serves as a movement controller that controls, for example, driving, stopping, and a traveling direction of the vehicle, which is a moving object, based on the output of the ECU 101. The display unit 103, serving as a display, includes a display element such as a liquid crystal display or an organic light-emitting diode (OLED) display and is mounted on the vehicle 100.

In the present embodiment, the ECU 101 receives information on the recognition result from the recognition unit 201. The ECU 101 can perform vehicle stop control (e.g., automatic braking control) depending on the recognition result. The ECU 101 receives an image from the image processing unit 200 and transmits the image and the recognition result to the display unit 103.

The display unit 103 provides, based on the output of the ECU 101, the image captured by the imaging element 9, the recognition result of the recognition unit 201, and various pieces of information on, for example, a traveling state of the vehicle 100 to a driver of the vehicle by using a graphical user interface (GUI), for example.

For example, the image processing unit 200 and the recognition unit 201 in Fig. 2 do not necessarily need to be mounted on the vehicle 100. The image processing unit 200 and the recognition unit 201 may be included in, for example, an external terminal disposed apart from the vehicle 100 and configured to remotely control the vehicle 100 or to monitor traveling of the moving object.

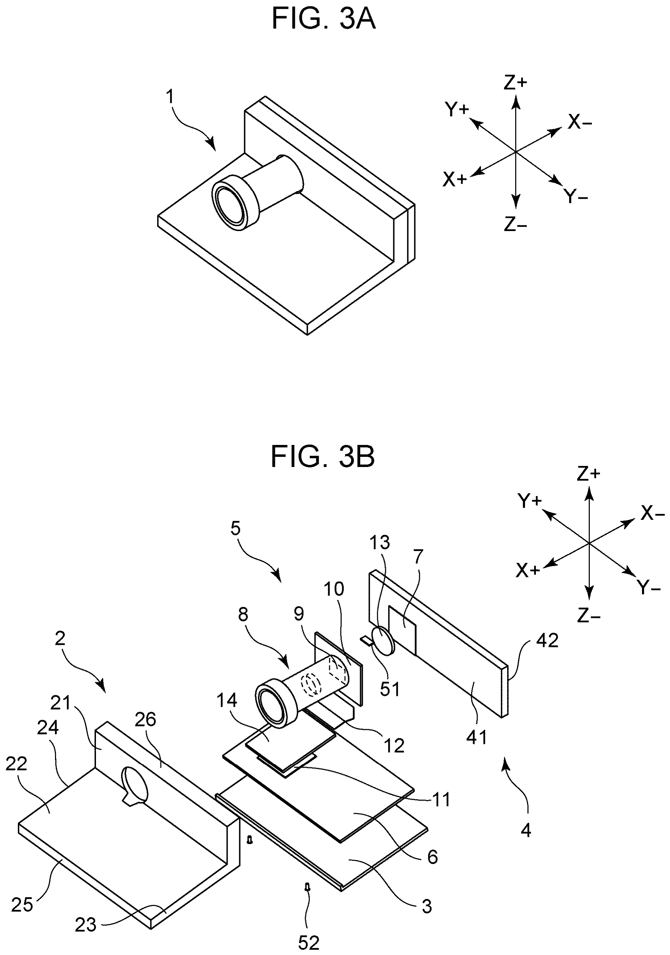

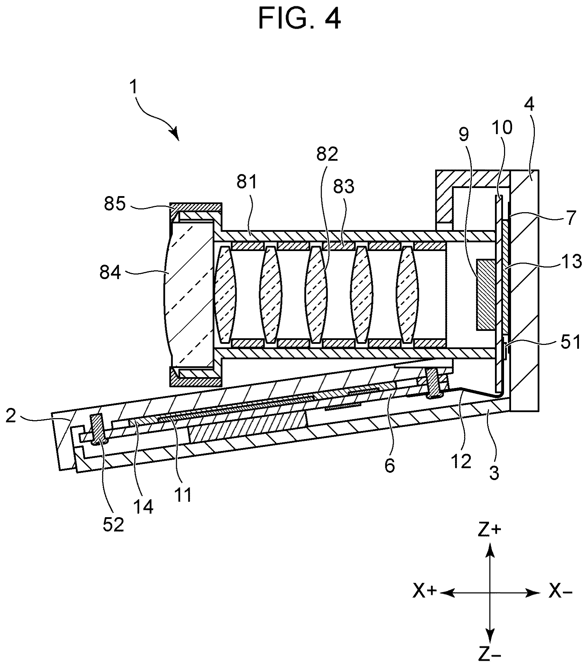

Figs. 3A and 3B illustrate the imaging apparatus 1 according to the present embodiment of the present disclosure. Fig. 3A is a perspective view of the imaging apparatus 1. Fig. 3B is an exploded perspective view of the imaging apparatus 1. Fig. 4 is a sectional view of the imaging apparatus 1 according to the present embodiment of the present disclosure.

As illustrated in Fig. 3B, the imaging apparatus 1 according to the present embodiment includes a housing that mainly includes an upper housing portion 2, a lower housing portion 3, and a rear housing portion 4. The housing holds an imaging element unit 5 and a body substrate 6.

The upper housing portion 2 is made of metal such as aluminum or resin and serves as a shell of the imaging apparatus 1 in the X-positive direction. The upper housing portion 2 includes a front wall 21, an upper wall 22, a right wall 23, a left wall 24, a front end wall 25, and a top wall 26. The front wall 21 is flat and is substantially parallel to the imaging element 9, which will be described later. The front wall 21 has an opening through which the imaging element unit 5 extends. The upper wall 22 intersects the front wall 21. The upper wall 22 extends from an end face of the front wall 21 in the X-positive direction and slightly slopes in the Z-negative direction. The upper wall 22 is flat and has a hole to avoid interference with the imaging element unit 5. The hole connects to the opening of the front wall 21. The upper wall 22 may have a radiating fin (not illustrated) thereon in the Z-positive direction. The body substrate 6 carrying electronic components, which will be described later, is attached to the upper wall 22 in the Z-negative direction. The front wall 21 of the upper housing portion 2 is disposed to face the outside of the vehicle. Although not illustrated in Figs. 3A and 3B, the upper housing portion 2 mainly serves as an attachment to be attached to the vehicle.

The lower housing portion 3 is made of metal such as aluminum or resin and serves as a shell of the imaging apparatus 1 in the Z-negative direction. The lower housing portion 3 is flat and is parallel to the upper wall 22. The lower housing portion 3 is disposed to close the upper housing portion 2 in the Z-negative direction.

The rear housing portion 4 is made of metal such as aluminum or resin and serves as a shell of the imaging apparatus 1 in the X-negative direction. The rear housing portion 4 includes a front wall 41 disposed substantially parallel to an imaging element substrate 10. The rear housing portion 4 is joined to the upper housing portion 2 with a fastener (not illustrated) such as a screw. The rear housing portion 4 includes a rear wall 42, to which a radiating fin (not illustrated) may be attached.

The imaging element unit 5 mainly includes the image-forming optical system 8, the imaging element 9 (sensor component), and the imaging element substrate 10.

The image-forming optical system 8 includes a cylindrical lens barrel 81 made of metal such as aluminum or resin, multiple lenses 82, and multiple spacers 83 such that the lens barrel 81 contains the lenses 82 and the spacers 83. A wide-angle lens 84 as a first lens is disposed at an end of the lens barrel 81 adjacent to an object to be imaged. The wide-angle lens 84 is held by a retaining ring 85.

The lenses 82 and the wide-angle lens 84 are made of a transparent material such as glass or resin. The spacers 83 and the retaining ring 85 are made of metal such as aluminum or resin.

Referring to Fig. 4, the lenses 82 having the same shape are equal in number to the spacers 83 having the same shape. The lenses 82 and the spacers 83 are alternately arranged. The lenses 82 may have different shapes. The spacers 83 may have different shapes. The lenses 82 may be different in number from the spacers 83. Furthermore, the lenses 82 and the spacers 83 may be arranged in any order.

An end of the image-forming optical system 8 is attached at substantially right angles to the imaging element substrate 10 with an adhesive (not illustrated), for example.

The image-forming optical system 8 does not necessarily need to be directly attached to the imaging element substrate 10. The image-forming optical system 8 may be indirectly attached to the imaging element substrate 10 with, for example, the upper housing portion 2 or another member therebetween.

The imaging element 9 (sensor component) is attached to a surface of the imaging element substrate 10 adjacent to the image-forming optical system 8 and is enclosed in the lens barrel of the image-forming optical system 8. The imaging element 9 is a main heat source in the imaging element unit 5.

The imaging element substrate 10 is flat and extends in the Y and Z directions. A surface of the imaging element substrate 10 remote from the image-forming optical system 8 has a temperature sensor 51 thereon. The temperature sensor 51 is used to determine the temperature of the imaging element 9 or the image-forming optical system 8.

The imaging element unit 5 extends through the opening of the upper housing portion 2 and is joined to the upper housing portion 2 with a screw or adhesive (not illustrated), for example. A thermally conductive member 13 is disposed on a surface of the imaging element unit 5 that faces in the X-negative direction. The thermally conductive member 13 is an elastic thin film made of silicone, for example. The thermally conductive member 13 is formed with a material called a curable paste or a gap filler, for example. The thermally conductive member 13 has a soft, creamy texture when applied to a component, causing little mechanical stress when brought into close contact with the component.

After application, the thermally conductive member 13 cures through a chemical reaction to a hardness similar to that of low-hardness rubber and is bonded or joined to the component in close contact therewith. The thermally conductive member 13 has such features.

A sheet member 7 is disposed on a surface of the thermally conductive member 13 that faces in the X-negative direction. Furthermore, the sheet member 7 is in contact with the front wall 41 of the rear housing portion 4 to transfer heat from, for example, the imaging element 9, to the rear housing portion 4. The sheet member 7 is a film or sheet made of metal or resin, for example.

The thermally conductive member 13 may be partly in contact with the front wall 41 of the rear housing portion 4. Heat received by the front wall 41 of the rear housing portion 4 is dissipated mainly from the rear wall 42. The sheet member 7 can have a thermal conductivity of 50 W/m·k or more in the in-plane direction.

The body substrate 6 is flat and extends in the X and Y directions. The body substrate 6 is joined to bosses of the upper wall 22 of the upper housing portion 2 with fasteners, such as screws 52. The body substrate 6 may be joined to the lower housing portion 3. The body substrate 6 and the imaging element substrate 10 are electrically connected by wiring 12. The body substrate 6 has multiple electronic components on its both surfaces facing in the Z-positive and Z-negative directions. The electronic components mounted on the body substrate 6 include a camera control integrated circuit (IC) 11.

The camera control IC 11 controls the entire imaging apparatus 1 in a centralized manner. A thermally conductive member 14 is disposed on a surface of the camera control IC 11 that faces in the Z-positive direction. The thermally conductive member 14 is in contact with at least a subset of the electronic components including the camera control IC 11. The thermally conductive member 14 is in contact with a surface of the upper wall 22 of the upper housing portion 2 that faces in the Z-negative direction to transfer heat from the electronic components to the upper wall 22. The heat received by the surface of the upper wall 22 of the upper housing portion 2 facing in the Z-negative direction is dissipated from a surface of the upper wall 22 that faces in the Z-positive direction. Another thermally conductive member 14 may be disposed on a surface of the body substrate 6 that faces in the Z-negative direction to enhance heat dissipation.

Advantages of the imaging apparatus 1 according to the present embodiment will now be described.

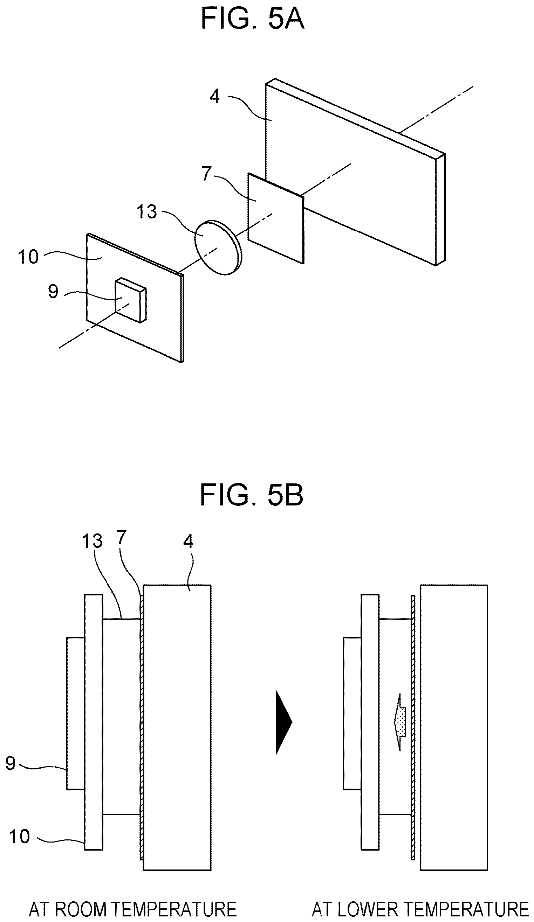

Figs. 5A and 5B are diagrams illustrating a portion including the thermally conductive member 13 in the present embodiment of the present disclosure. Fig. 5A is an exploded perspective view of the portion including the thermally conductive member 13. Fig. 5B includes sectional views of the portion including the thermally conductive member 13 at room temperature and at lower temperature. The term "at lower temperature" in Fig. 5B means that the imaging apparatus 1 is at a temperature lower than room temperature due to a change in ambient temperature. Referring to Fig. 5B, the thermally conductive member 13 and the sheet member 7 (hatched portion in Fig. 5B) are arranged on the imaging element substrate 10 carrying the imaging element 9 in that order. At room temperature, the sheet member 7 is in contact with the rear housing portion 4. Although not illustrated in Figs. 5A and 5B, the imaging element substrate 10 and the rear housing portion 4 are secured to other components including the upper housing portion 2. Although the thermally conductive member 13 is joined to the imaging element substrate 10 and the sheet member 7, a surface of the sheet member 7 adjacent to the rear housing portion 4 is merely in pressure contact with the rear housing portion 4.

In other words, one surface of the thermally conductive member 13 is joined to the imaging element substrate 10, and the other surface thereof is joined to the sheet member 7. One surface of the sheet member 7 is joined to the thermally conductive member 13, and the other surface thereof is not joined to the rear housing portion 4.

After placement at room temperature, the thermally conductive member 13 expands in an environment at or above room temperature, so that the sheet member 7 remains in contact with the rear housing portion 4. Conversely, the thermally conductive member 13 contracts in an environment below room temperature (at lower temperature). At lower temperature, the sheet member 7 is movable away from the rear housing portion 4 in the direction of an arrow in Fig. 5B.

If the sheet member 7 were not disposed, the thermally conductive member 13 would be joined to both the imaging element substrate 10 and the rear housing portion 4. In such a configuration, if the thermally conductive member 13 contracted at lower temperature as in Fig. 5B, each of the imaging element substrate 10 and the rear housing portion 4 would receive a load acting in a direction to the thermally conductive member 13.

The load would shift the imaging element substrate 10 and the position of the imaging element 9 on the imaging element substrate 10, causing a change in the focus position.

As described above, the sheet member 7 allows the thermally conductive member 13 to move together with the sheet member 7 away from the rear housing portion 4 without pulling the imaging element substrate 10. Such a configuration prevents a shift in the position of the imaging element 9, thus preventing a change in the focus position. For ease of placement, the sheet member 7 may have low adhesion and be stuck on the rear housing portion 4.

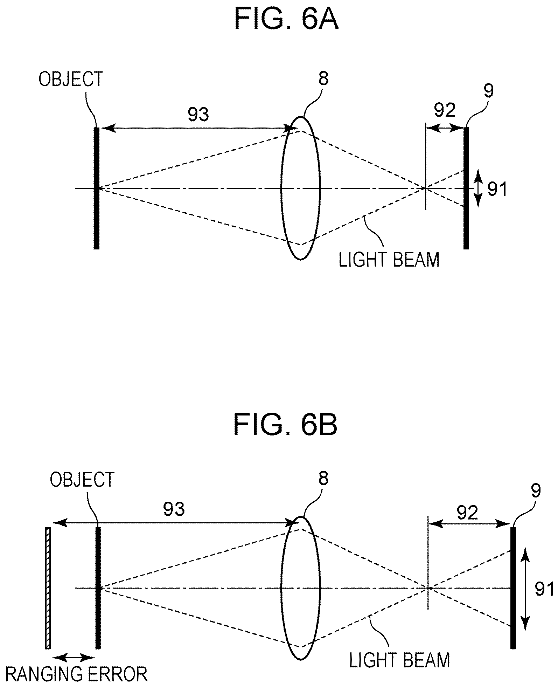

Figs. 6A and 6B are conceptual diagrams illustrating the principle of distance determination in the first embodiment. Fig. 6A illustrates no change in the focus position. Fig. 6B illustrates a change in the focus position as compared with that in Fig. 6A.

The imaging apparatus 1 according to the present embodiment is able to acquire ranging information. The imaging element 9 included in the imaging apparatus 1 acquires a phase difference 91, which is the difference between image signals, for each pixel based on light (broken lines in Figs. 6A and 6B) through the image-forming optical system 8 from an object to be imaged by using the principle of triangulation. The imaging element 9 has a configuration in which each pixel includes multiple photodiodes, and has a function of measuring a phase difference with such a configuration. The imaging element 9 has a function of calculating a distance to the object based on the phase difference. Multiplying the phase difference 91 by a factor set for each imaging apparatus yields a defocus amount 92. The defocus amount 92 can be converted into a distance 93 to the object by using lens design values (focal length, focus distance) and a lens formula. Fig. 6B illustrates a shift of the imaging element 9 relative to the position illustrated in Fig. 6A caused by contraction of the thermally conductive member 13, which is not illustrated in Figs. 6A and 6B. The actual amount of shift is a few micrometers. Figs. 6A and 6B demonstrate a change in the phase difference 91 and a change in the defocus amount 92 caused by the shift of the imaging element 9. To determine an accurate distance to the object to be imaged, the defocus amount 92 is calculated from the phase difference 91. The distance 93 is calculated based on the defocus amount 92. A shift in the position of the imaging element 9 leads to a change in the distance to the object (hatched portion in Fig. 6B), causing a ranging error.

To prevent the imaging element 9 from shifting, a load on the imaging element substrate 10 is reduced by using the sheet member 7, which has been described with reference to Fig. 5B. As a result, as illustrated in Fig. 6A, the imaging element 9 is retained at a position as intended in design. The distance 93 to the object can be calculated accurately.

As described above, the imaging apparatus 1 according to the first embodiment of the present disclosure includes the sheet member 7 disposed on the thermally conductive member 13. Such a configuration reduces a load on the imaging element substrate 10 when the thermally conductive member 13 contracts at lower temperature, thus keeping the imaging element 9 from shifting. This readily reduces the likelihood of a change in the focus position, resulting in improved ranging accuracy.

### Second Embodiment

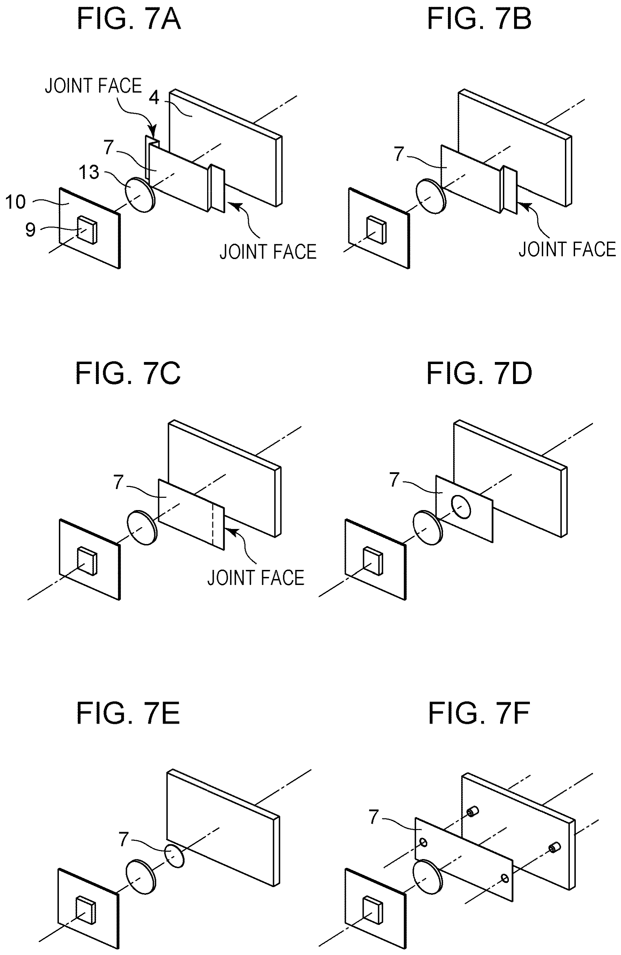

An imaging apparatus 1 according to a second embodiment of the present disclosure will be described with reference to Figs. 7A to 7F.

The first embodiment has described how to reduce a load induced by contraction of the thermally conductive member 13 by using the sheet member 7. The second embodiment will describe variations in shape of the sheet member 7 and the effect of reducing a contraction-induced load. The imaging apparatus according to the second embodiment is basically similar to that in the first embodiment. The following description will focus on the difference between the first and second embodiments, and a description of the same components and parts as those in the first embodiment will be omitted. Components and parts identical to those in the first embodiment are assigned identical reference signs for description.

Figs. 7A to 7F are exploded perspective views of a portion including the thermally conductive member 13 in the second embodiment. Fig. 7A illustrates the sheet member 7 subjected to bending and thus having spring elasticity.

The sheet member 7, which is rectangular, is bent at two positions at different predetermined distances from each end thereof in its longitudinal direction, or at four positions in total. The sheet member 7 is bent such that a bending direction at a first position closer to the end than a second position is different from that at the second position. As illustrated in Fig. 7A, a portion of the sheet member 7 that extends from the end thereof in the longitudinal direction to the first position is a face (joint face in Fig. 7A) to be joined to the rear housing portion 4. The sheet member 7 is joined and fixed to the rear housing portion 4, resulting in higher assembly productivity. Furthermore, a highly thermally conductive sheet, such as a graphite sheet, used as the sheet member 7 can improve heat conduction when joined to the rear housing portion 4. The sheet member 7 can be joined to the rear housing portion 4 with an adhesive, a double-faced tape, or a screw, for example. Z-shaped bending allows the sheet member 7 to be spaced from the rear housing portion 4 when the joint faces are joined to the rear housing portion 4. Thus, the sheet member 7 joined to the rear housing portion 4 exhibits spring elasticity such that the sheet member is movable in a direction along a dash-dot line in Fig. 7A. Therefore, the spring elasticity of the sheet member 7 can reduce a contraction-induced load if the thermally conductive member 13 contracts.

Fig. 7B illustrates the sheet member 7 subjected to bending in a manner similar to that in Fig. 7A and having spring elasticity. Unlike the sheet member 7 in Fig. 7A, the sheet member 7 in Fig. 7B has a single joint face and two bends and is fixed in a cantilevered manner. As in Fig. 7A, Z-shaped bending allows the sheet member 7 to be spaced from the rear housing portion 4 when the joint face is joined to the rear housing portion 4. Thus, the sheet member 7 joined to the rear housing portion 4 exhibits spring elasticity such that the sheet member is movable in a direction along a dash-dot line in Fig. 7B. Therefore, the spring elasticity of the sheet member 7 can reduce a contraction-induced load if the thermally conductive member 13 contracts.

Fig. 7C illustrates the sheet member 7 joined at a single joint face and being flexible. Like the sheet member 7 in Fig. 7B, the sheet member 7 in Fig. 7C is fixed in a cantilevered manner. However, unlike the sheet member 7 in Fig. 7B, the sheet member 7 in Fig. 7C is not subjected to bending. As illustrated in Fig. 7C, the sheet member 7 is rectangular. A portion of the sheet member 7 that extends from one end in the longitudinal direction to a predetermined position is joined to the rear housing portion 4. As long as the sheet member 7 is made of a flexible material, the sheet member 7 is bendable or pivotable about the joined end (indicated by a broken line in Fig. 7C). Therefore, the flexibility of the sheet member 7 can reduce a contraction-induced load if the thermally conductive member 13 contracts.

Fig. 7D illustrates the sheet member 7 having an opening through which the thermally conductive member 13 is joined to the rear housing portion 4. The opening of the sheet member 7 allows the thermally conductive member 13 in contact with the sheet member 7 to be joined to the rear housing portion 4 through the opening of the sheet member 7. The thermally conductive member 13 joined to the rear housing portion 4 reduces thermal resistance, thus efficiently transferring heat from the imaging element substrate 10 to the rear housing portion 4. A portion of the sheet member 7 that is in contact with the thermally conductive member 13 can reduce a load. However, a portion of the thermally conductive member 13 that is joined to the rear housing portion 4 may apply a load to the imaging element substrate 10 when contracting. Adjusting the position and size of the opening of the sheet member 7 and the number of openings thereof regulates the amount of load. Appropriate adjustment of the opening of the sheet member 7 is effective in reducing the impact on the imaging element 9.

Fig. 7E illustrates the sheet member 7 having a smaller area than that of the thermally conductive member 13 and thus allowing the thermally conductive member 13 to be joined to the rear housing portion 4. The sheet member 7, which is smaller than the thermally conductive member 13, is covered by the thermally conductive member 13. As illustrated in Fig. 7E, the circular sheet member 7 is placed at the center of the circular thermally conductive member 13. Thus, a portion of the thermally conductive member 13 that is joined to the rear housing portion 4 is ring-shaped. The sheet member 7 reduces a load in a central portion of the thermally conductive member 13. Although the rear housing portion 4 joined to the portion of the thermally conductive member 13 experiences a load, the joint between the thermally conductive member 13 and the rear housing portion 4 reduces thermal resistance. This enables heat from the imaging element substrate 10 to efficiently transfer to the rear housing portion 4. Although Fig. 7E illustrates the circular sheet member 7 placed at the center of the thermally conductive member 13, the sheet member 7 may have any shape other than a circle. The sheet member 7 may be placed at any position other than the center of the thermally conductive member 13.

Fig. 7F illustrates how to retain the sheet member 7. As illustrated in Fig. 7F, the rear housing portion 4 includes two bosses, and the sheet member 7 has two holes. The two bosses of the rear housing portion 4 extend through the two holes of the sheet member 7, thus retaining the sheet member 7 during and after assembly. The sheet member 7 is movable in a direction along dash-dot lines in Fig. 7F. This does not interfere with the effect of reducing a contraction-induced load. Retaining the sheet member 7 facilitates positioning of the sheet member 7 during assembly and prevents misalignment of the sheet member 7 with the thermally conductive member 13 after assembly. Although Fig. 7F illustrates the sheet member 7 retained using the bosses and the holes, the outside shape of the sheet member 7 may be used to retain the sheet member 7.

### Modification of Second Embodiment

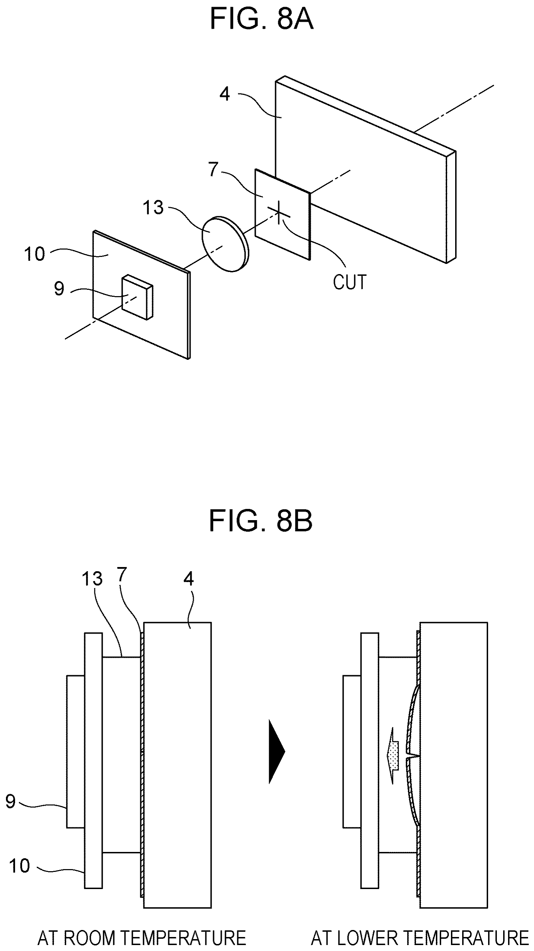

An imaging apparatus 1 according to a modification of the second embodiment of the present disclosure will be described with reference to Figs. 8A and 8B.

The first embodiment has described how to reduce a load induced by contraction of the thermally conductive member 13 by using the sheet member 7. The modification of the second embodiment will describe the sheet member 7 having a cut and the effect of reducing a contraction-induced load by using the sheet member 7 with such a shape. The imaging apparatus according to the modification of the second embodiment is basically similar to that in the first embodiment. The following description will focus on the difference between the first embodiment and the modification of the second embodiment, and a description of the same components and parts as those in the first embodiment will be omitted. Components and parts identical to those in the first embodiment are assigned identical reference signs for description.

Figs. 8A and 8B are diagrams illustrating a portion including the thermally conductive member 13 in the modification of the second embodiment. Fig. 8A is an exploded perspective view of the portion including the thermally conductive member 13. Fig. 8B includes sectional views of the portion including the thermally conductive member 13 at room temperature and at lower temperature. The configuration is the same as that in Figs. 5A and 5B in the first embodiment. The modification of the second embodiment differs from the first embodiment in that the sheet member 7 has a cut at the center thereof. The cut can be located in a portion of the sheet member 7 to be in contact with the thermally conductive member 13. As illustrated in Fig. 8A, the sheet member 7 has a cross-shaped cut at the center. If the sheet member 7 is partly joined to the rear housing portion 4, a portion of the sheet member 7 that has the cut can bend in the direction of an arrow in Fig. 8B at lower temperature. In other words, the portion with the cut of the sheet member 7 is displaceable in response to contraction of the thermally conductive member 13. Therefore, if the thermally conductive member 13 contracts, the portion with the cut of the sheet member 7 can bend, thus reducing a contraction-induced load.

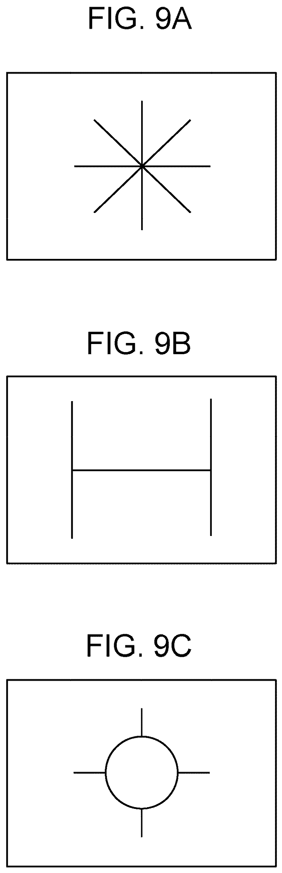

Figs. 9A to 9C illustrate various cuts in the sheet member 7 in the modification of the second embodiment. In the modification of the second embodiment, the sheet member 7 has a cross-shaped cut at the center. The cut may have any shape other than a cross. Cuts with various shapes offer the same advantages.

Fig. 9A illustrates an X-shaped cut added to the cross-shaped cut. The cross-shaped cut provides four central parts of the sheet member 7, whereas the X-shaped cut added to the cross-shaped cut provides eight central parts of the sheet member 7. The eight central parts allow the sheet member 7 to bend easily.

Fig. 9B illustrates an H-shaped cut. This cut provides two central parts of the sheet member 7. This enables the effect of reducing a contraction-induced load to hardly change if the position of the thermally conductive member 13 placed on the sheet member 7 is slightly different from an intended position in the longitudinal direction of the sheet member 7.

Fig. 9C illustrates a circular opening added to the cross-shaped cut. As described above with reference to Fig. 7D, the added opening allows a thermally conductive cured paste to directly contact the housing, thus reducing thermal resistance.

Figs. 9A to 9C illustrate example variations. Various shaped cuts including a U-shaped cut and a star-shaped cut can be used depending on circumstances.

### Third Embodiment

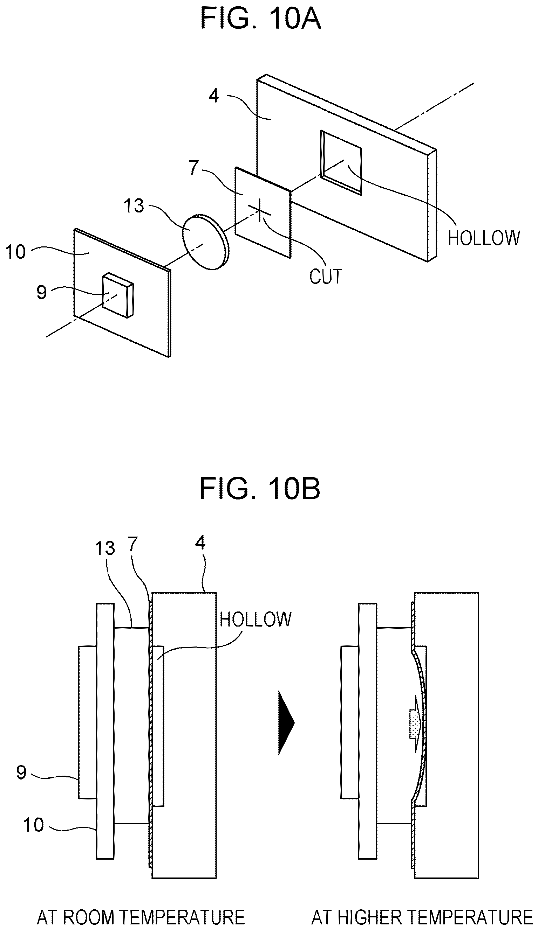

An imaging apparatus 1 according to a third embodiment of the present disclosure will be described with reference to Figs. 10A and 10B.

The first embodiment has described how to reduce a load induced by contraction of the thermally conductive member 13 by using the sheet member 7. The third embodiment will describe how to reduce a load induced by expansion of the thermally conductive member 13 by using a hollow in the rear housing portion 4. The imaging apparatus according to the third embodiment is basically similar to that in the first embodiment. The following description will focus on the difference between the first and third embodiments, and a description of the same components and parts as those in the first embodiment will be omitted. Components and parts identical to those in the first embodiment are assigned identical reference signs for description.

Figs. 10A and 10B are diagrams illustrating a portion including the thermally conductive member 13 in the third embodiment. Fig. 10A is an exploded perspective view of the portion including the thermally conductive member 13. Fig. 10B includes sectional views of the portion including the thermally conductive member 13 at room temperature and at higher temperature. The term "at higher temperature" in Fig. 10B means that the imaging apparatus 1 is at a temperature higher than room temperature due to a change in ambient temperature. The configuration in Figs. 10A and 10B is the same as that in Figs. 5A and 5B in the first embodiment. The third embodiment differs from the first embodiment in that the rear housing portion 4 has a hollow.

The first and second embodiments have described how to reduce a load induced by contraction of the thermally conductive member 13 at lower ambient temperature. The third embodiment will describe how to reduce a load induced by expansion of the thermally conductive member 13 at higher ambient temperature. In the third embodiment, an expansion-induced load acts in a direction opposite to the direction in which the load acts in the first and second embodiments. The expansion-induced load can press the imaging element substrate 10 carrying the imaging element 9, so that the imaging element 9 can shift in a direction opposite to the shift direction of the imaging element 9 described with reference to Fig. 6B.

Although the shift direction differs from that in Fig. 6B, a ranging error also occurs in a manner similar to that in Fig. 6B. For this reason, as illustrated in Figs. 10A and 10B, the rear housing portion 4 has a hollow to provide a space for expansion of the thermally conductive member 13. At room temperature in Fig. 10B, the sheet member 7 remains flat and the hollow in the rear housing portion 4 has a space. At higher temperature, the thermally conductive member 13 expands in the direction of an arrow in Fig. 10B. An expanding part of the thermally conductive member 13 contacts the rear housing portion 4, thus reducing thermal resistance. This results in improved heat dissipation. The expanding part of the thermally conductive member 13 enters the hollow in the rear housing portion 4, thus reducing an expansion-induced load.

As described above, the hollow in the rear housing portion 4 reduces a load applied to the imaging element substrate 10 from the thermally conductive member 13. This prevents a shift in the position of the imaging element 9 and a change in the focus position.

### First Modification of Third Embodiment

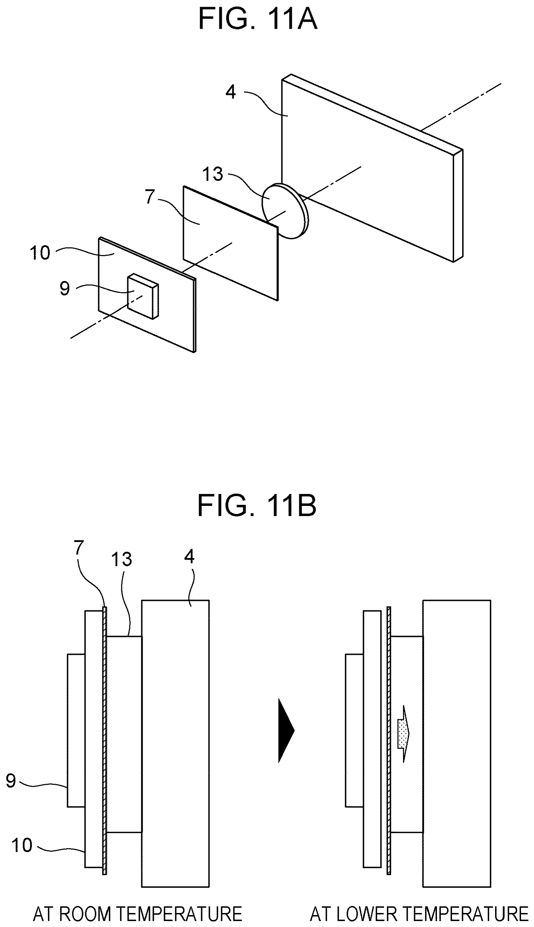

An imaging apparatus 1 according to a first modification of the third embodiment of the present disclosure will be described with reference to Figs. 11A and 11B.

The first embodiment has described how to reduce a load induced by contraction of the thermally conductive member 13 by using the sheet member 7. In the first modification of the third embodiment, the sheet member 7 is disposed next to the imaging element substrate 10 (sensor substrate), and the thermally conductive member 13 is disposed on the housing. The effect of reducing a contraction-induced load in such a configuration will be described. The imaging apparatus according to the first modification of the third embodiment is basically similar to that in the first embodiment. The following description will focus on the difference between the first embodiment and the first modification of the third embodiment, and a description of the same components and parts as those in the first embodiment will be omitted. Components and parts identical to those in the first embodiment are assigned identical reference signs for description.

Figs. 11A and 11B are diagrams illustrating a portion including the thermally conductive member 13 in the first modification of the third embodiment. Fig. 11A is an exploded perspective view of the portion including the thermally conductive member 13. Fig. 11B includes sectional views of the portion including the thermally conductive member 13 at room temperature and at lower temperature. Components are the same as those in Figs. 5A and 5B in the first embodiment. The first modification of the third embodiment differs from the first embodiment in that the sheet member 7 is disposed next to the imaging element substrate 10 (sensor substrate). As illustrated in Figs. 11A and 11B, the imaging element substrate 10, the sheet member 7, the thermally conductive member 13, and the rear housing portion 4 are arranged in that order. At lower temperature in Fig. 11B, the thermally conductive member 13 contracts, and the sheet member 7 moves toward the rear housing portion 4 in a direction (indicated by an arrow in Fig. 11B) opposite to the direction in which the sheet member 7 moves in the first embodiment. The sheet member 7 is movable away from the imaging element substrate 10. Thus, if the thermally conductive member 13 contracts, movement of the sheet member 7 can reduce a contraction-induced load, thus preventing a shift in the position of the imaging element 9.

### Second Modification of Third Embodiment

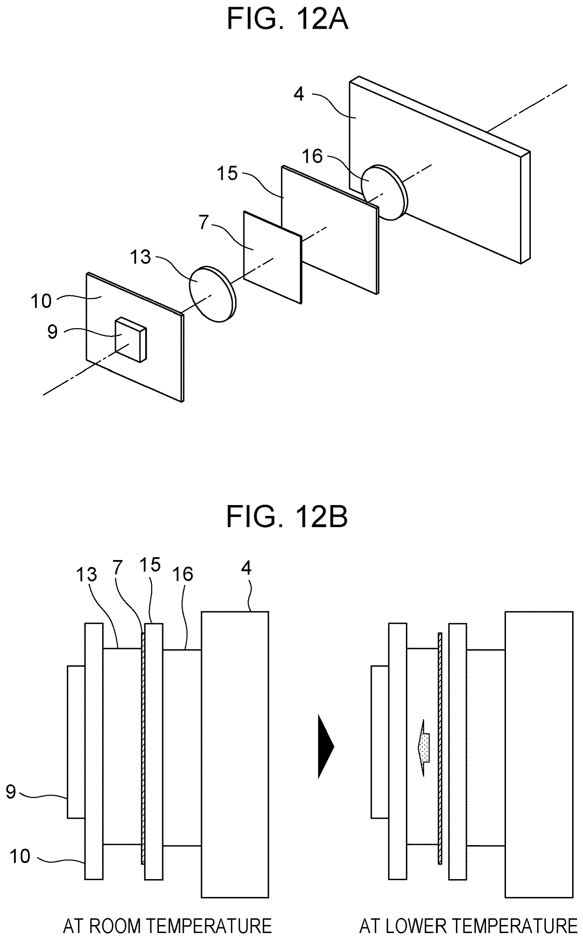

An imaging apparatus 1 according to a second modification of the third embodiment of the present disclosure will be described with reference to Figs. 12A and 12B.

The first embodiment has described how to reduce a load induced by contraction of the thermally conductive member 13 by using the sheet member 7. A configuration in the second modification of the third embodiment further includes a substrate 15 and a thermally conductive member 16. The effect of reducing a contraction-induced load in such a configuration will be described. The imaging apparatus according to the second modification of the third embodiment is basically similar to that in the first embodiment. The following description will focus on the difference between the first embodiment and the second modification of the third embodiment, and a description of the same components and parts as those in the first embodiment will be omitted. Components and parts identical to those in the first embodiment are assigned identical reference signs for description.

Figs. 12A and 12B are diagrams illustrating a portion including the thermally conductive member 13 in the second modification of the third embodiment. Fig. 12A is an exploded perspective view of the portion including the thermally conductive member 13. Fig. 12B includes sectional views of the portion including the thermally conductive member 13 at room temperature and at lower temperature. The basic configuration in Figs. 12A and 12B includes additional components, or the substrate 15 and the thermally conductive member 16, as compared with that in the first embodiment illustrated in Figs. 5A and 5B. The substrate 15 is fixed (not illustrated in Figs. 12A and 12B) to a component such as the rear housing portion 4. The thermally conductive member 16 is joined to the substrate 15 and the rear housing portion 4. As illustrated in Fig. 12B, at room temperature, the thermally conductive member 13, the sheet member 7, the substrate 15, the thermally conductive member 16, and the rear housing portion 4 are arranged in that order on the imaging element substrate 10 carrying the imaging element 9, and adjoining components of these components are in contact with each other. Such a configuration in Figs. 12A and 12B allows heat from the imaging element substrate 10 to transfer to the rear housing portion 4. If the thermally conductive member 13 contracts at lower temperature, the sheet member 7 can move away from the substrate 15 in the direction of an arrow in Fig. 12B. This reduces a contraction-induced load, thus preventing a shift in the position of the imaging element 9.

### Third Modification of Third Embodiment

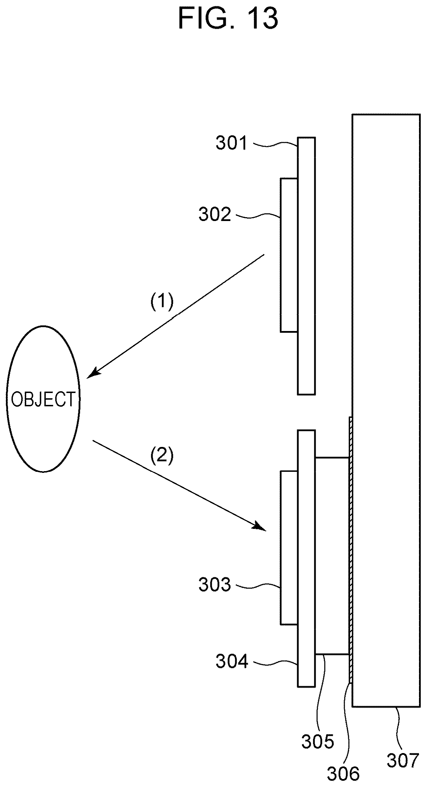

A sensor apparatus according to a third modification of the third embodiment of the present disclosure will be described with reference to Fig. 13.

The first embodiment has described how to reduce a load induced by contraction of the thermally conductive member 13 by using the sheet member 7 in the imaging apparatus 1 to prevent shifting of the imaging element 9. The third modification of the third embodiment will describe the effect of reducing a shift in the position of a sensor in another sensor apparatus other than the imaging apparatus by using a sheet member and a thermally conductive cured paste. Advantages of the sensor apparatus according to the third modification of the third embodiment are basically the same as those in the first embodiment. The following description will focus on the difference between the first embodiment and the third modification of the third embodiment, and a description of the same components and parts will be omitted.

Fig. 13 is a sectional view of the sensor apparatus according to the third modification of the third embodiment. The sensor apparatus of Fig. 13 is a distance measurement apparatus including a light emitter and a light-receiving sensor. Fig. 13 illustrates components, including the sensor, necessary for measurement.

A light-emitter substrate 301 carries a light emitter 302, which emits light for distance measurement (indicated by an arrow (1) in Fig. 13). Upon reaching an object, the emitted light is reflected by the object. The reflected light (indicated by an arrow (2) in Fig. 13) reaches a light-receiving sensor 303 on a light-receiving-sensor substrate 304. A distance can be measured by using the emitted light and the reflected light. For example, the time-of-flight (TOF) method or the phase-difference detection method can be used. The TOF method includes converting a period from the time when light is emitted to the time when reflected light is received into a distance. The phase-difference detection method includes measuring a phase difference between emitted light and reflected light to determine a period and converting the period into a distance. To dissipate heat from, for example, the light-receiving sensor 303, a thermally conductive cured paste 305 and a sheet member 306 are arranged on the light-receiving-sensor substrate 304. The sheet member 306 is in contact with a housing 307. Such a configuration allows heat in the light-receiving-sensor substrate 304 to be transferred to the housing 307 due to heat conduction. When the sensor apparatus decreases in temperature, as described above with reference to Fig. 5B, the sheet member 306 moves away from the housing 307 in response to contraction of the thermally conductive cured paste 305. This reduces a load induced by contraction of the thermally conductive cured paste 305, thus preventing a shift of the position of the light-receiving sensor 303. Other Embodiments

The imaging apparatuses according to the embodiments of the present disclosure have been described above. However, embodiments are not particularly limited to the above embodiments. The present disclosure can also be embodied in various modifications and improvements that can be made by those skilled in the art.

In the above embodiment, the imaging element 9 (sensor component) is a CMOS image sensor. The imaging element 9 may be a single photon avalanche diode (SPAD) image sensor, for example.

The material of a curable paste for the thermally conductive members 13 and 14 is not particularly limited to a silicone-based material. For example, urethane or modified silicone may be used. The curable paste may be made of, for example, two or more materials that cure when mixed or a single curable material.

For the sheet member 7, a material having higher thermal conductivity reduces thermal resistance, leading to higher efficiency of heat dissipation. For this reason, for example, a graphite sheet, copper foil, or aluminum foil may be used. The material may be in the form of fiber or may be in the form of foam.

One or more embodiments of the present disclosure provides a sensor apparatus that reduces the impact of thermal expansion or contraction of a thermally conductive cured paste caused by temperature change on a sensor component fixed to a sensor substrate and thus exhibits improved measurement accuracy.

Embodiment(s) of the present disclosure can also be realized by a computer of a system or apparatus that reads out and executes computer executable instructions (e.g., one or more programs) recorded on a storage medium (which may also be referred to more fully as a 'non-transitory computer-readable storage medium') to perform the functions of one or more of the above-described embodiment(s) and/or that includes one or more circuits (e.g., application specific integrated circuit (ASIC)) for performing the functions of one or more of the above-described embodiment(s), and by a method performed by the computer of the system or apparatus by, for example, reading out and executing the computer executable instructions from the storage medium to perform the functions of one or more of the above-described embodiment(s) and/or controlling the one or more circuits to perform the functions of one or more of the above-described embodiment(s). The computer may comprise one or more processors (e.g., central processing unit (CPU), micro processing unit (MPU)) and may include a network of separate computers or separate processors to read out and execute the computer executable instructions. The computer executable instructions may be provided to the computer, for example, from a network or the storage medium. The storage medium may include, for example, one or more of a hard disk, a random-access memory (RAM), a read only memory (ROM), a storage of distributed computing systems, an optical disk (such as a compact disc (CD), digital versatile disc (DVD), or Blu-ray Disc (BD)^{™}), a flash memory device, a memory card, and the like.

Various embodiments have been described in detail above but it will be understood that the present disclosure is not limited to these embodiments and encompasses all modifications, variants, alternatives and equivalents falling within the scope of the appended claims.

## Claims

1. A sensor apparatus (1) comprising:
a housing (4);
a sensor component (9);
a sensor substrate (10) carrying the sensor component (9);
a cured paste (13) located on a surface of the sensor substrate (10) that is adjacent to the housing (4); and
a sheet member (7) located between the cured paste (13) and the housing (4),
wherein the sensor substrate (10), the cured paste (13), the sheet member (7), and the housing (4) are arranged in that order, and each of the sensor substrate (10), the cured paste (13), the sheet member (7), and the housing (4) is in contact with an adjoining one of the sensor substrate (10), the cured paste (13), the sheet member (7), and the housing (4) to transfer heat from the sensor substrate (10) to the housing (4) through the cured paste (13) and the sheet member (7).

2. The sensor apparatus (1) according to claim 1, wherein
the sensor substrate (10) is joined to the cured paste (13),
the cured paste (13) has a first surface joined to the sensor substrate (10) and a second surface joined to the sheet member (7), and
the sheet member (7) has a first surface joined to the cured paste (13) and a second surface that is not joined to the housing (4).

3. The sensor apparatus (1) according to claim 1 or 2, wherein
the sheet member (7) is bent at first and second positions that are at different predetermined distances from at least one end, and
a portion of the sheet member (7) that extends from the one end to the first position is joined to the housing (4).

4. The sensor apparatus (1) according to claim 1 or 2, wherein the sheet member (7) includes a portion that extends from at least one end to a predetermined position and that is joined to the housing (4).

5. The sensor apparatus (1) according to claim 1 or 2, wherein the cured paste (13) and the housing (4) are in contact with each other.

6. The sensor apparatus (1) according to claim 5, wherein the sheet member (7) has an opening, and the cured paste (13) and the housing (4) are joined to each other through the opening.

7. The sensor apparatus (1) according to claim 5, wherein the sheet member (7) is smaller than the cured paste (13) such that the sheet member (7) is covered by the cured paste (13) and the cured paste and the housing (4) are joined to each other around the periphery of the sheet member (7).

8. A sensor apparatus comprising:
a housing (4);
a sensor component (9);
a sensor substrate (10) carrying the sensor component (9);
a cured paste (13) located on a surface of the housing (4) that is adjacent to the sensor substrate (10); and
a sheet member (7) located between the cured paste (13) and the sensor substrate (10),
wherein the sensor substrate (10), the sheet member (7), the cured paste (13), and the housing (4) are arranged in that order, and each of the sensor substrate (10), the sheet member (7), the cured paste (13), and the housing (4) is in contact with an adjoining one of the sensor substrate (10), the sheet member (7), the cured paste (13), and the housing (4) to transfer heat from the sensor substrate (10) to the housing (4) through the sheet member (7) and the cured paste (13).

9. The sensor apparatus according to claim 8, wherein the cured paste (13) and the sensor substrate (10) are in contact with each other.

10. The sensor apparatus according to claim 1, 2 or 9, wherein
the sheet member (7) includes a portion that is in contact with the cured paste (13) and that includes a cut, and
the portion including the cut is displaceable in response to contraction or expansion of the cured paste (13).

11. A sensor apparatus comprising:
a housing (4);
a sensor component (9);
a sensor substrate (10) carrying the sensor component (9);
a second substrate (15) different from the sensor substrate (10);
a cured paste (13) located on a surface of the sensor substrate (10) that is adjacent to the housing (4);
a second cured paste (16) located on a surface of the second substrate (15) that is adjacent to the housing (4); and
a sheet member (7) located between the cured paste (13) and the second substrate (15),
wherein the sensor substrate (10), the cured paste (13), the sheet member (7), the second substrate (15), the second cured paste (16), and the housing (4) are arranged in that order, and each of the sensor substrate (10), the cured paste (13), the sheet member (7), the second substrate (15), the second cured paste (16), and the housing (4) is in contact with an adjoining one of the sensor substrate (10), the cured paste (13), the sheet member (7), the second substrate (15), the second cured paste (16), and the housing (4) to transfer heat from the sensor substrate (10) to the housing (4) through the cured paste (13), the sheet member (7), the second substrate (15), and the second cured paste (16).

12. The sensor apparatus according to any one of the preceding claims, wherein the sensor component (9) is an imaging element, includes a plurality of photodiodes for each pixel, and has a function of measuring a phase difference and a function of calculating, based on the phase difference, a distance to an object to be imaged.

13. The sensor apparatus according to any one of the preceding claims, wherein the sheet member (7) has a thermal conductivity of 50 W/m·k or more in an in-plane direction.
